# EUROPÄISCHE PATENTANMELDUNG

(11) **EP 2 242 177 A2**
(43) Veröffentlichungstag der Anmeldung: **20.10.2010**
(21) Anmeldenummer: 10000855.6
(22) Anmeldetag: 28.01.2010
(51) Int. Cl.: H03H 7/24

(54) **Pegelsteller**

(30) Priorität: 16.04.2009 DE 102009017689
(71) Anmelder: ASC-TEC AG Antennen-Satelliten-Communication-Technik, 78351 Bodman (DE)
(72) Erfinder: Alj, Reda, 78351 Bodmann-Ludwigshafen (DE); Boll, Christian, 78351 Bodmann-Ludwigshafen (DE)
(74) Vertreter: Arat, Dogan

(57) **Zusammenfassung**

Pegelsteller (1), insbesondere passiver Hochfrequenz-Pegelsteller (1), mit mindestens einem Stellwiderstand (6), der einen Abtastbereich und einen dem Abtastbereich zugeordneten einstellbaren Abtaster (9) umfasst, wobei der Abtastbereich ausgebildet ist, so dass durch eine Einstellung des Abtasters (9) stufenweise Widerstandswerte abtastbar sind.

## Beschreibung

Die vorliegende Erfindung betrifft einen Pegelsteller nach dem Oberbegriff des Anspruchs 1.

### Stand der Technik

Aus dem Stand der Technik sind Pegelsteller für Hochfrequenz-Verstärker bekannt, mit welchen sich der Pegel eines HF-(Hochfrequenz)-Signals einstellen lässt. Für moderne Fernsehempfangsanlagen werden dabei häufig elektronisch einstellbare Pegelsteller verwendet, die sich auf bestimmte Dämpfungen bzw. Verstärkungen wiederholbar programmieren lassen. Nachteilig an solchen Anlagen ist jedoch, dass sie vergleichsweise teuer sind.

Ausserdem sind aus dem Stand der Technik Pegelsteller bekannt, welche über Stellwiderstände verfügen. Nachteilig an diesen herkömmlichen Pegelstellern ist allerdings, dass sich nicht zuverlässig wiederholbare Zwischenwerte bei der Dämpfung einstellen lassen. Zwar verfügen solche Pegelsteller und deren Stellwiderstände unter Umständen über Skalen, die von einer Dämpfung von 0 bis zu einem bestimmten Wert reichen. In der Praxis werden allerdings dann häufig Dämpfungen benötigt, die Zwischenwerten dieser Bereiche entsprechen, wobei keine eindeutig wiederholbare Einstellung auf einen solchen Zwischenwert, beispielsweise bei Austausch eines Bauteils, möglich ist.

### Aufgabe

Aufgabe der Erfindung ist es daher, die Nachteile des o. g. Standes der Technik zu beheben oder zuminstest zu lindern, insbesondere ist es Aufgabe der Erfindung einen Pegelsteller anzugeben, welcher mit einfachen Mitteln eine wiederholbare Einstellung bestimmter Dämpfungspegel ermöglicht.

### Lösung der Aufgabe

Die Aufgabe wird gelöst durch einen Pegelsteller nach Anspruch 1. Die Erfindung sieht vor, dass ein Stellwiderstand mit einem Abtastbereich und einem dem Abtastbereich zugeordneten einstellbaren Abtaster verwendet wird, wobei der Abtastbereich ausgebildet ist, so dass durch eine Einstellung des Abtasters stufenweise Widerstandswerte abtastbar sind. Auf diese Weise wird durch eine Einstellung des Abtasters zwangsweise ein Widerstandswert aus einer Menge diskreter Widerstandswerte abgetastet. Im Gegensatz zu herkömmlichen Stellwiderständen, die über eine stufenlos abtastbare Abtastbahn verfügen, verfügt der Abtastbereich also über stufenweise abtastbare Widerstandswerte. Auf diese Weise lässt sich erreichen, dass mit baugleichen Pegelstellern wiederholt identische oder zumindest im Bereich von Herstellungstoleranzen identische Widerstandswerte eingestellt werden. Dies bietet den Vorteil, dass defekte Teile einfach ausgetauscht werden können, ohne dass eine Neueinmessung eines Pegels notwendig ist. Lediglich muss beim alten Pegelsteller ein auf einer Skala eingestellter Wert abgelesen werden und dieser Wert identisch beim Ersatzbauteil eingestellt werden. Ausserdem wird auf diese Weise die Einstellung einer vorhersagbaren Dämpfung ermöglicht. Im Gegensatz zu einer stufenlosen Abtastbahn bietet der stufenweise Abtastbereich den Vorteil, dass durch Anwahl einer bestimmten Stufe ein bestimmter Widerstandswert ausgewählt wird, so dass eine bestimmte Dämpfung lediglich durch Einstellen erreicht wird, wobei ein Nachmessen ggf. überflüssig wird. Der Pegelsteller ist vorzugsweise ein elektromechanisches Bauteil, das gegenüber rein elektronischen Bauteilen den Vorteil eines einfacheren Aufbaus aufweist.

Vorteilhafterweise umfasst der Abtastbereich mindestens zwei elektrisch leitende Abtastflächen zum Abtasten durch den Abtaster, die durch einen definierten Widerstand verbunden sind. Besonders bevorzugt wird eine Ausführungsform mit mindestens drei oder mehr Abtastbereichen, die seriell durch definierte Widerstände verbunden sind, wobei die Widerstände zwischen den Abtastbereichen vorzugsweise unterschiedlich sind. Der Hintergrund ist, dass für Pegelstellerschaltungen für eine in gleichen Stufen zunehmende Dämpfung, die logarithmisch gemessen wird, eine nicht lineare Zunahme des gewählten Widerstandes benötigt wird. Es ist jedoch auch im Rahmen bevorzugter Ausführungsbeispiele möglich, einzelne Abtastbereiche durch einzelne Widerstände mit einem jeweiligen Eingang oder einem jeweiligen Ausgang zu verbinden.

Bei vorteilhaften Ausführungsformen sind mindestens zwei Stellwiderstände vorhanden, deren jeweilige Abtaster synchron mittels eines Stellers verstellbar sind. Dabei bedeutet eine synchrone Verstellbarkeit der Abtaster, dass die Abtaster jeweils um einen Schritt oder eine Stufe auf dem jeweiligen Abtastbereich weiterschalten, falls sie durch den Steller betätigt werden. Bei besonders bevorzugten Ausführungsformen erweisen die synchron mit dem Steller verstellbaren Stellwiderstände jeweils synchron durch die Abtaster abgetastete Abtastflächen auf, so dass bei jedem Stellwiderstand jeweils ein synchrones Abtasten diskreter Widerstandswerte ermöglicht wird. Auf diese Weise ist es möglich, mit dem einen Steller gleichzeitig mehrere stufenweise einstellbare Stellwiderstände synchron anzusteuern, so dass auch Pegelsteller-Widerstands-Anordnungen verschiedener Art, bei denen mehrere Widerstände gleichzeitig verändert werden müssen, um eine veränderte Dämpfung bei gleicher Eingangs- oder Ausgangs-Impedanz zu erreichen, möglich sind. Bevorzugte Ausführungsformen weisen Stellwiderstände auf, welche in Pi-Anordnung verschaltet sind, wobei die jeweiligen Abtaster synchron mittels des Einstellers verstellbar sind. Andere bevorzugte Ausführungsformen weisen eine H-Anordnung der Stellwiderstände oder eine andere Anordnung der Stellwiderstände wie beispielsweise eine L-Anordnung auf. Die Pi-Anordnung bietet den besonderen Vorteil, dass mit lediglich drei Stellwiderständen eine einstellbare Dämpfung bei gleich bleibender Eingangs- und Ausgangs-Impedanz ermöglicht wird.

Vorzugsweise sind die Widerstandswerte der den Abtastflächen der Stellwiderstände zugeordneten Widerstände gewählt, so dass sich bei dem synchronen Abtasten der Abtastflächen jeweils eine definierte Dämpfung ergibt. Dies bietet den Vorteil, dass durch Einstellen des nur einen Stellers verschiedene, definierte Dämpfungen anwählbar sind. Besonders bevorzugt wird, falls die die Abtastflächen verbindenden Widerstände gewählt sind, so dass definierte Dämpfungen mit einem definierten Schrittmaß einstellbar sind. Dieses eine definierte Schrittmaß kann beispielsweise 2 dB betragen oder auch 3 dB. Besonders bevorzugt wird eine Schrittweite von 2 dB, wobei vorzugsweise Dämpfungen von 0 dB, 2 dB, 4 dB usw. einstellbar sind bis vorzugsweise mindestens 10 dB.

Vorzugsweise ist der Pegelsteller bzw. sind die Stellwiderstände des Pegelstellers so eingerichtet, dass sich bei einem synchronen Abtasten der Abtastflächen und damit der entsprechenden definierten Widerstände eine im Wesentlichen gleich bleibende Impedanz eines Ausgangs oder eines Eingangs des Pegelstellers ergibt. Diese Impedanz beträgt vorzugsweise 50 oder 75 Ohm. Dies ist beispielsweise zu erreichen mittels einer H-förmigen Anordnung der Stellwiderstände oder auch mit der oben genannten Pi-förmigen Anordnung. Wird die Pi-förmige Anordnung der Stellwiderstände gewählt, so können beispielsweise für eine Dämpfung in dB = LOG (n) die Widerstandswerte der den Eingang und den Ausgang der Pi-Schaltung zur Masse hin abschließenden Widerstände R1 und R2 gewählt werden zu: R1 = R2 = Z* (n+1) / (n-1), wobei Z der Impedanz entspricht. Der zwischen dem Eingang und dem Ausgang liegende Widerstand R3 ergibt sich dann zu R3 = Z* (n* n-1) / (2*n). Vorteilhafterweise werden nun die stufenweise abtastbaren Widerstandswerte entsprechend dieser Formeln gewählt.

Vorzugsweise umfasst der Pegelsteller ein Substrat, auf welchem die Stellwiderstände angeordnet sind. Dies ermöglicht einen besonders kompakten und preisgünstigen Aufbau des Pegelstellers. Vorteilhafterweise sind die Abtastbereiche der Stellwiderstände mit den Abtastflächen auf konzentrischen Kreisbahnteilstücken angeordnet, wobei die Abtastflächen der einzelnen Stellwiderstände untereinander jeweils im Wesentlichen denselben Winkelabstand aufweisen. Dabei bedeutet im Wesentlichen einen Winkelabstand, der im Betrieb ausreicht, um eine synchrones Abtasten der jeweiligen Abtastflächen zu ermöglichen. Durch die konzentrische Anordnung wird erreicht, dass die verschiedenen Abtaster durch einen Steller verstellt werden können, der lediglich um eine einzelne Achse drehbar sein muss. Auf diese Weise ist es möglich, durch Drehen einer einzigen Welle mehrere Stellwiderstände, also bevorzugt mindestens 3 Stellwiderstände, einzustellen.

Vorteilhafterweise wird der Pegelsteller in einem vergossenem Gehäuse untergebracht, wobei dies einen Schutz der in dem Gehäuse angeordneten Komponenten vor Umwelteinflüssen, insbesondere beim Auflöten des Pegelstellers auf eine Platine, gewährleistet. Es ist möglich, die Anschlussdrähte des Pegelstellers auf einer beliebigen Seite des Gehäuses herauszuführen, wobei auf diese Weise ermöglicht wird, dass die Welle des Pegelstellers beispielsweise durch einen Zugang von oben auf die Platine verdreht werden kann, auf welcher der Pegelsteller montiert ist. Ebenso kann der Pegelsteller allerdings so montiert sein, dass sich die Welle des Pegelstellers parallel zu der Ebene der Platine drehen lässt.

### Figurenbeschreibung

Im Folgenden wird ein bevorzugtes Ausführungsbeispiel der Erfindung anhand einiger schematischer Zeichnungen beschrieben, wobei die Zeichnungen zeigen:
Figur 1 schematisch eine Seitenansicht eines erfindungsgemäßen Pegelstellers;
Figur 2 eine schematische Draufsicht auf den erfindungsgemäßen Pegelsteller der Figur 1;
Figur 2A einen schematischen Schaltplan des Pegelstellers der Figur 1 und 2: und
Figur 3 schematisch die Anordnung von Abtastbereichen und von Abtastern auf einem Substrat innerhalb eines Gehäuses des Pegelstellers der Figuren 1 und 2.

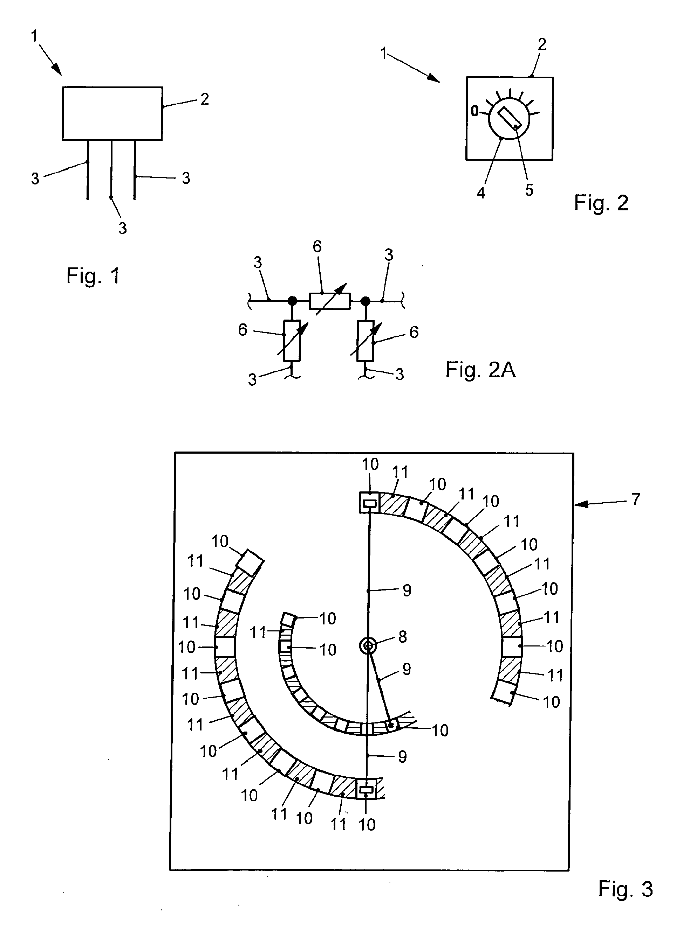

In der Figur 1 ist ein erfindungsgemäßer Pegelsteller 1 schematisch in einer Seitenansicht gezeigt. Der Pegelsteller 1 verfügt über ein Gehäuse 2, dass eine Kapselform aufweist, und aus dem an der Unterseite drei Anschlüsse 3 herausragen. Das kapselförmige Gehäuse 2 ist von der Unterseite her, auf welcher die Anschlüsse 3 herausragen, vergossen, so dass die inneren Komponenten des Pegelstellers 1 geschützt sind. Die drei Anschlüsse 3 sind ein Eingang und ein Ausgang des Pegelstellers und Masse.

In der Figur 2 ist der Pegelsteller 1 der Figur 1 nochmals in einer Draufsicht schematisch gezeigt, wobei für gleiche Teile gleiche Bezugszeichen wie bei der Beschreibung der Figur 1 verwendet werden. An der in der Figur 2 zu sehenden Oberseite des Gehäuses 2 ist ein Steller 4 angeordnet, welcher mit einer Welle im Inneren des Gehäuses 2 verbunden ist, wobei die Welle in Figur 1 nicht gezeigt ist. Die Welle wird nachfolgend im Zusammenhang mit der Figur 3 näher erläutert. Der Steller 4 verfügt über einen mittig angeordneten Schlitz 5, in den ein Schraubendreher zum Verstellen des Stellers 4 eingeführt werden kann. Dieser kann auf 6 verschiedene Positionen gedreht werden, welche durch Striche gekennzeichnet sind. Der in der Figur 2 ganz links dargestellte Strich entspricht dabei einer Dämpfung des Pegelstellers von 0 dB.

Durch Verdrehen des Stellers 4 auf einen der anderen Teilstriche als den ganz links gezeigten Teilstrich lässt sich die Dämpfung des Pegelstellers 1 verändern, wobei ein Strich jeweils einer zusätzlichen Dämpfung von 2 dB entspricht. Es sollte hinzugefügt werden, dass der Steller über eine gleich bleibende Impedanz von 75 Ohm verfügt, wobei die unterschiedliche Dämpfung bei gleich bleibender Impedanz durch eine Pi-förmige Anordnung der Stellwiderstände in der Schaltung des Pegelstellers 1 erreicht wird. Die Figur 2A zeigt die entsprechende Anordnung der Stellwiderstände 6 in der Schaltung des Pegelstellers 1. Die Figur 2A zeigt schematisch ein idealisiertes, vereinfachtes Schaltbild des erfindungsgemäßen Pegelstellers, welche in den Figuren 1 und 2 dargestellt ist. Allerdings sollte berücksichtigt werden, dass die Stellwiderstände 6 der in der Figur 2A gezeigten Schaltung von einer besonderen Bauart sind, die im Folgenden im Zusammenhang mit der Figur 3 erläutert wird.

In der Figur 3 ist ein in dem Gehäuse 2 angeordnetes Substrat 7 schematisch zusammen mit den auf dem Substrat 7 angeordneten Bauelementen gezeigt. Das Substrat 7 ist horizontal in dem Gehäuse 2 eingebaut. In der Mitte des Substrats 7 befindet sich eine Öffnung für eine Welle 8, welche mit dem Steiler 4 verbunden ist. Durch Drehen an dem Steller 4 wird die Welle 8 gedreht. An der Welle 8 wiederum befestigt sind drei Abtaster 9, welche jeweils dazu geeignet sind, Abtastflächen 10 der verschiedenen Stellwiderstände 6 abzutasten. Der Übersichtlichkeit halber sind in der Figur 3 nicht alle Abtastflächen 10 mit einem Bezugszeichen 10 versehen. Die Abtastflächen 10 bilden 3 Gruppen, die wiederum jeweils einen Abtastbereich bilden. Zu erkennen sind die Abtastbereiche daran, dass ein Abtastbereich jeweils sechs im gleichen Winkelabstand beabstandete Abtastflächen 10 umfasst. Die Abtastflächen 10 eines Abtastbereichs befinden sich jeweils auf einem Kreissegment eines Kreises um die Welle 8. Zwischen den Abtastflächen 10 eines Abtastbereichs sind jeweils Widerstände 11 angeordnet. Wiederum sind nicht alle Widerstände 11 mit einem Bezugszeichen versehen. Ausdrücklich festzuhalten bleibt, dass die Widerstände 11 trotz der gleichen Bezugszeichen teilweise unterschiedliche Widerstandswerte aufweisen. Der Hintergrund dieses Umstands wird im Folgenden im Zusammenhang mit der Funktionsweise des Pegelstellers 1, welcher in den Figuren 1 bis 3 dargestellt ist, erläutert.

Die beiden auf der äußeren Kreisbahn in der Figur 3 angeordneten Abtastbereiche von Abtastflächen 10 sind Teil der Stellwiderstände 6 der Figur 2A, welche jeweils den Eingang oder den Ausgang des Pegelstellers 1 zur Masse hin abschließen. Durch Einstellen der Abtaster 9 auf verschiedene der Abtastflächen 10 können verschiedene Widerstandswerte für diese Stellwiderstände 6, welche den Eingang und den Ausgang nach Masse abschließen, abgegriffen werden, wobei auf beiden Abtastbereichen jeweils bei einer Drehung an dem Steller 4 und damit der Welle 8 gleiche Widerstandswerte abgegriffen werden. Dadurch, dass alle Abtaster 9 mit der Welle 8 fest verbunden sind, erfolgt das Abtasten der Widerstandswerte jeweils synchron. Synchron mit dem Abtasten der jeweiligen Abtastflächen 10 der Abtastbereiche der Stellwiderstände, welche nach Masse abschließen, wird ein weiterer Stellwiderstand 6 abgegriffen, welcher in Serie zwischen dem Eingang und dem Ausgang des Pegelstellers 1 liegt (siehe Figur 2A). Die Abtastflächen dieses Stellwiderstandes sind auf dem in der Figur 3 innen liegenden Kreis angeordnet. Die Widerstände 11 zwischen den Abtastflächen 10 dieses Stellwiderstandes 6, welcher in Serie zwischen dem Eingang und dem Ausgang des Pegelstellers geschaltet ist, sind unterschiedlich gegenüber den Widerständen 11 der anderen Widerstände 6. Der Hintergrund wird im allgemeinen Teil dieser Beschreibung im Zusammenhang mit den entsprechenden Formeln für eine Pi-förmige Anordnung von Widerständen für Pegelsteller erläutert. Auf diese Weise lassen sich durch Drehen an dem Steller 4 und damit an der Welle 8 synchron verschiedene Widerstandswerte für die Stellwiderstände 6 abtasten, wobei das Abtasten dieser Widerstandswerte stufenweise erfolgt. Wird der Steller 4 nicht auf die Stellung eines der in der Figur 2 gezeigten Striche oder wenigstens ungefähr auf eine solche Lage gestellt, so greifen die Abtaster 9 nicht auf Abtastflächen 10 zu und entsprechend der in der Figur 2A gezeigten Schaltung überträgt dann der Pegelsteller 1 gar kein Signal. Dies verhindert eine Fehlbedienung des Pegelstellers 1, so dass der Pegelsteller 1 nur auf definierte Dämpfungswerte einstellbar ist. Die Widerstände 11 des Pegelstellers 1 sind dabei so gewählt, dass eine Dämpfung in 2 dB-Schritten von 0 bis 10 dB möglich ist, wobei gleichzeitig die Eingangsimpedanz und die Ausgangsimpedanz des Pegelstellers 1 konstant auf 75 Ohm gehalten wird.

Im Betrieb bietet der erfindungsgemäße Pegelsteller 1 nun allgemein die Vorteile, dass eine einfache Einstellung auf definierte Dämpfungswerte möglich ist, die auch bei Austausch von Bauteilen wiederholbar ist. Dies macht ein Messen überflüssig. Die Dämpfungsschritte betragen dabei vorzugsweise mindestens 1 dB oder noch bevorzugter mindestens 2 dB.

Die Erfindung ist nicht auf das zuvor beschriebene bevorzugte Ausführungsbeispiel beschränkt. Vielmehr wird der Umfang der Erfindung durch die Ansprüche bestimmt.

**Bezugszeichenliste**

| | | | | | |
|---|---|---|---|---|---|
| 1 | Pegelsteller | 34 | | 67 | |
| 2 | Gehäuse | 35 | | 68 | |
| 3 | Anschlüsse | 36 | | 69 | |
| 4 | Steller | 37 | | 70 | |
| 5 | Schlitz | 38 | | 71 | |
| 6 | Stellwiderstand | 39 | | 72 | |
| 7 | Substrat | 40 | | 73 | |
| 8 | Welle | 41 | | 74 | |
| 9 | Abtaster | 42 | | 75 | |
| 10 | Abtastfläche | 43 | | 76 | |
| 11 | Widerstand | 44 | | 77 | |
| 12 | | 45 | | 78 | |
| 13 | | 46 | | 79 | |
| 14 | | 47 | | | |
| 15 | | 48 | | | |
| 16 | | 49 | | | |
| 17 | | 50 | | | |
| 18 | | 51 | | | |
| 19 | | 52 | | | |
| 20 | | 53 | | | |
| 21 | | 54 | | | |
| 22 | | 55 | | | |
| 23 | | 56 | | | |
| 24 | | 57 | | | |
| 25 | | 58 | | | |
| 26 | | 59 | | | |
| 27 | | 60 | | | |
| 28 | | 61 | | | |
| 29 | | 62 | | | |
| 30 | | 63 | | | |
| 31 | | 64 | | | |
| 32 | | 65 | | | |
| 33 | | 66 | | | |

## Patentansprüche

1. Pegelsteller (1), insbesondere passiver Hochfrequenz-Pegelsteller (1), mit mindestens einem Stellwiderstand (6), der einen Abtastbereich und einen dem Abtastbereich zugeordneten einstellbaren Abtaster (9) umfasst,
**dadurch gekennzeichnet,**
**dass** der Abtastbereich ausgebildet ist, so dass durch eine Einstellung des Abtasters (9) stufenweise Widerstandswerte abtastbar sind.

2. Pegelsteller (1) nach Anspruch 1, **dadurch gekennzeichnet, dass** der Abtastbereich mindestens zwei separate, elektrisch leitende Abtastflächen (10) umfasst.

3. Pegelsteller (1) nach einem der vorhergehenden Ansprüche, **dadurch gekennzeichnet, dass** mindestens zwei Stellwiderstände (6) vorhanden sind, deren jeweilige Abtaster (9) synchron mittels eines Stellers (4) verstellbar sind.

4. Pegelsteller (1) nach Anspruch 3, **dadurch gekennzeichnet, dass** die synchron mit dem Steller (4) verstellbaren Stellwiderstände (6) jeweils synchron durch die Abtaster (9) abgetastete Abtastflächen (10) aufweisen, so dass bei jedem Stellwiderstand (6) jeweils ein synchrones Abtasten diskreter Widerstandswerte ermöglicht wird.

5. Pegelsteller (1) nach einem der vorhergehenden Ansprüche, **dadurch gekennzeichnet, dass** drei in Pi-Anordnung verschaltete Stellwiderstände (6) vorhanden sind, deren jeweilige Abtaster (9) synchron mittels des Stellers (4) verstellbar sind.

6. Pegelsteller (1) nach Anspruch 5, **dadurch gekennzeichnet, dass** die Widerstandswerte der den Abtastflächen (10) der Stellwiderstände (6) zugeordneten Widerstände (11) gewählt sind, so dass sich bei dem synchronen Abtasten der Abtastflächen (10) jeweils eine definierte Dämpfung ergibt.

7. Pegelsteller (1) nach Anspruch 6, **dadurch gekennzeichnet, dass** die den Abtastflächen (10) zugeordneten Widerstände (11) gewählt sind, so dass definierte Dämpfungen mit einem definierten Schrittmaß einstellbar sind.

8. Pegelsteller (1) nach Anspruch 6 oder 7, **dadurch gekennzeichnet, dass** sich bei dem synchronen Abtasten eine im Wesentlichen gleich bleibende Impedanz eines Ausgangs und/oder eines Eingangs des Pegelstellers (1) ergibt.

9. Pegelsteller (1) nach einem der vorhergehenden Ansprüche, **gekennzeichnet durch** ein Substrat (7), auf welchem die Stellwiderstände (6) zumindest teilweise angeordnet sind.

10. Pegelsteller (1) nach einem der vorhergehenden Ansprüche, **dadurch gekennzeichnet, dass** die Abtastflächen (10) der Stellwiderstände (6) auf konzentrischen Kreisbahnteilstücken mit im Wesentlichen demselben Winkelabstand angeordnet sind.

11. Pegelsteller (1) nach einem der vorhergehenden Ansprüche, **gekennzeichnet durch** ein vergossenes Gehäuse (2).
